# EUROPEAN PATENT APPLICATION

(11) **EP 1 411 556 A1**
(43) Date of publication of application: **21.04.2004**
(21) Application number: 02023371.4
(22) Date of filing: 18.10.2002
(51) Int. Cl.: H01L 31/02, H01L 31/048

(54) **Photovoltaic product and process of fabrication thereof**

(71) Applicant: VHF Technologies SA, 2400 Le Locle (CH)
(72) Inventor: Fischer, Diego, 2000 Neuchhatel (CH); Torres, Pedro, M192QR Manchester (GB); Keppner, Herbert, 2013 Colombier (CH)
(74) Representative: Saam, Christophe

(57) **Abstract**

Sealed electric power generating product including:
a base plate,
a power generating film laminated over said base plate,
at least one contact portion for contacting at least one pole of said power generating film,
an electric conductor going through a blind hole perforated after the lamination through said base plate and between the internal side of said base plate and said contact portion, said electric conductor being electrically connected with said contact portion.

## Description

The present invention relates to a sealed electric power generating product, such as, for example, a wall covering panel or a tile including a solar cell.

It has already been suggested in the prior art to use solar cells for covering building walls or roofs. In most cases, solar cells made of crystalline silicium, i.e. produced on wafers, are used for that purpose. However, wafers tend to be expensive when used for covering large surfaces. Furthermore, crystalline silicium breaks easily and is thus only poorly adapted for external uses.

One also knows solar panels comprising a flexible photovoltaic film mounted on a rigid base plate comprising mounting means for mounting it on a wall or on a roof. A plurality of similar panels or tiles are usually used and mutually connected for covering a building. Each product thus usually comprises at least two electric conductors for connecting it to its neighbours.

For safety and esthetical reasons, it is preferable to provide the electrical connectors on the internal side of the product. Obviously, the solar cells must be provided on the external side of the product. This implies providing one or more holes through the base plate for leading the electrical connectors from the contact portions of the solar cells to the internal side of the product.

Solar cells are sensitive to water and dust. This implies sealing the whole product in order to prevent any infiltrations. For that, at least the external side of the product is often covered with a transparent encapsulation layer.

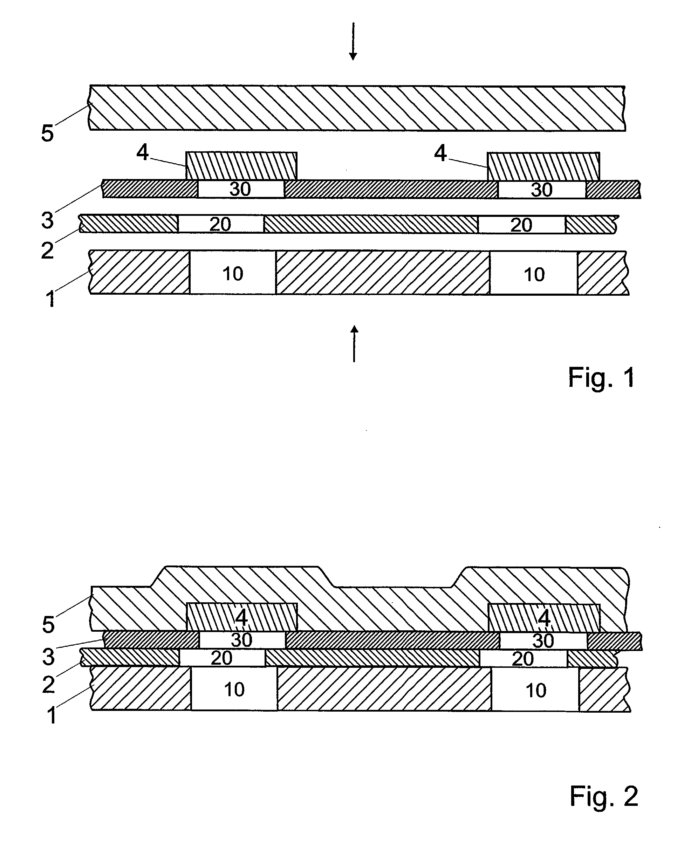

The process used for making conventional sealed electric power generating products is illustrated on Figures 1 to 3. On Figure 1, the different layers 1 to 5 are provided. The layer 1 is a rigid base plate that often already comprises some mounting means for mounting it on a building. Layer 2 is an adhesive, such as for example a double-sided adhesive film. Layer 3 is an electric power generating layer, such as a solar cell. Layer 3 may be produced by a separate process by laminating a plurality of silicon layers over a substrate.

A plurality of contact portions 4, in this example contact bands which extend perpendicularly to the surface of the Figure over substantially the whole length of the layer 3, are provided on the external side of the layer 3. Each contact portion 4 is electrically connected to one pole of the solar cell, so that a difference of potential will be generated between two contact points when light is received by the layer 3. A transparent encapsulation layer 5 may be provided for protecting the external side of the solar cell.

In conventional production processes, holes 10, 20, 30 are punched at predetermined positions through the layers 1, 2, 3 prior to the laminating process. The different layers are then pressed and laminated together, as illustrated on Figure 2.

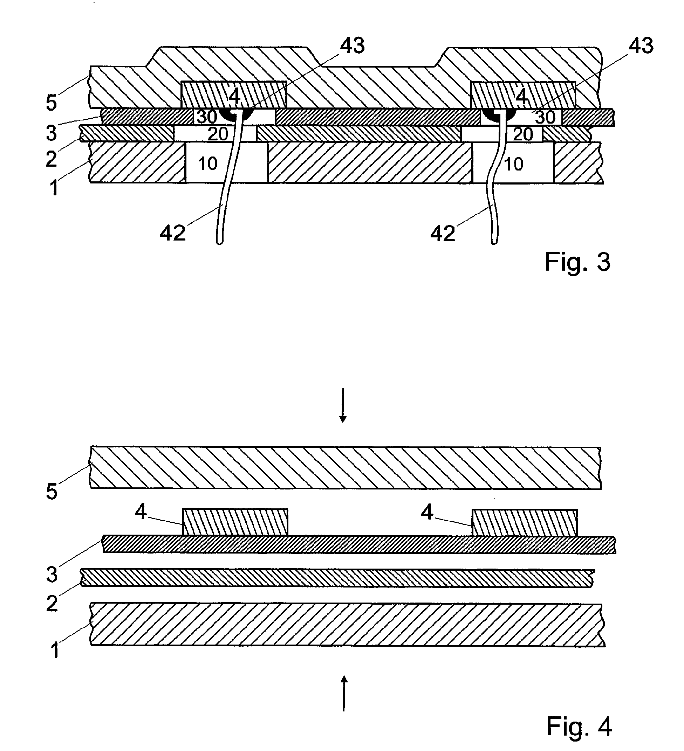

On Figure 3, an electrical conductor, in this example an electrical cable 42, is fed through the holes 10,20, 30 and welded to the contact portions 4. Reference number 43 illustrates the weld.

A problem that arises when laminating solar cells having large surfaces, such as the surfaces needed for products intended for architectural purposes, is the difficulty to ensure a precise alignment of the different layers 1,2,3,5. Even if one manages to align precisely the sides of the different layers, some layers would be stretched or deformed during the process, so that in the end portions of different layers that would be supposed to overlap may often be misaligned. As a result, the previously punched holes 10, 20, 30 through the different layers do not superimpose well, as schematically illustrated on Figure 2. In order to be sure to achieve a resulting hole through the various layers that still has a sufficient diameter, it is thus necessary to punch larger holes through all the layers. This however results in a weakness of the rigidity of the base structure, in an imperfect covering of this base structure 1 by the adhesive layer, and in an unwanted reduction of the useful surface of the power-generating layer. Furthermore, it results in the holes having irregular lateral sides through which it could be difficult, or even impossible, to penetrate an electrical conductor and to weld it to the contact portions 4.

It has also been suggested to make the contact between the electric connector 42 and the contact portion before the lamination process. It is however very difficult to take care of the position of the wires 42 during the lamination process, and to ensure the impermeability of the contact during this process.

It is an aim of the present invention to propose a sealed electric power generating product and a process of fabrication that is improved over the prior art systems, notably that does not have the inconveniences mentioned.

According to the invention, these aims are achieved by means of a sealed electric power generating product and a process of fabrication having the characteristics of the independent claims, variants of preferred embodiments being moreover described in the dependent claims.

In particular, these aims are achieved by means of a sealed electrical power generating product including a base plate, a power generating film laminated over said base plate, at least one contact portion for contacting at least one pole of said power generating film, an electric conductor going through a blind hole perforated after the lamination process through the base plate and between the internal side of said base plate and said contact portion, said electric conductor being electrically connected with said contact portion.

According to the invention, at least some blind holes go through the complete base plate and through the power generating film, so that a contact can be established with contact portions on the external side of the power generating film.

According to another aspect of the invention, the blind hole is drilled or milled through said base plate and preferably through said power generating layer. This has the advantage that it is relatively easy to control the depth of the blind hole with great precision. This has the further advantage that the lateral sides of a drilled or milled hole are very even, whereas the bottom of the hole is conical and rougher, allowing a more reliable welding of the electric conductor in the hole.

The fabrication method of the invention is easy to automate, providing a low-cost, high-yield manufacturing process. It is highly reliable and adapted for a continuous fabrication process.

The invention will be better understood with reference to the description of an embodiment illustrated by the attached drawings containing the figures, in which:
Figure 1 shows a cross-section through the various pre-punched layers before the laminating process of a sealed solar cell product in a prior art fabrication process.
Figure 2 shows a cross-section through the laminated pre-punched layers after the laminating process of a sealed solar cell product in a prior art fabrication process.
Figure 3 shows a cross-section through the resulting sealed solar cell product obtained by the prior art fabrication process, after welding of the electrical connectors.
Figure 4 shows a cross-section through the various layers before the laminating process of a sealed solar cell product in the inventive fabrication process.
Figure 5 shows a cross-section through the laminated layers after the laminating process of a sealed solar cell product in the inventive fabrication process.
Figure 6 shows a cross-section through the laminated layers of a sealed solar cell product after the laminating process and after the drilling or milling of the blind holes in the inventive fabrication process.
Figure 7 shows a cross-section through the resulting sealed solar cell product obtained by the inventive fabrication process, after welding of the electrical connectors.
Figure 8 shows a cross-section perpendicular to the cross-sections of Figures 1 to 7 through the laminated layers after the laminating process of a variant embodiment of a sealed solar cell product.
Figure 9 illustrates a device for laminating layers the laminated layers after the lamination process of a sealed solar cell product in the inventive fabrication process.

Figure 4 shows a cross-section through various layers used for fabricating a sealed solar cell product. It must be noted that the thickness of the different layers illustrated on the Figures is for illustrative purposes only and does not necessarily reflect in any way the thickness of the layers of a real product. In the illustrated embodiment, the different layers comprise a base plate 1, an adhesive layer 2, a solar-cell film 3 (power-generating layer), contact portions 4 and an encapsulation layer 5.

The base plate 1 is preferably made of a rigid or semi-rigid material, such as a metal plate, for example an aluminium plate, or preferably a sandwich construction with one layer of insulating synthetic material between two thinner layers of metal, for example aluminium. Other base plates may be used for other purposes.

The adhesive layer 2 is preferably an adhesive, such as for example a double-sided adhesive film, used for fastening the solar cells over the base plate. Other methods can be used for mounting the solar cells on the base plate.

The power generating cell 3 is preferably made of a flexible foil (substrate) over which an active voltage-generating layer has been applied by a plasma-vapor deposition process (PVD). In a preferred embodiment, the substrate can be made of a bendable material such as a polyimide film. The voltage-generating layer can comprise one or several coatings of silicon or silicon alloys coated over the whole area. In the case of an amorphous silicon solar cell, the voltage-generating layer may comprise at least one amorphous silicon p-i-n structure and/or n-i-p structure. Also, a stacked (or tandem) structure might be adopted to improve overall product performance and utility. Other voltage-generating layers may be used for converting a temperature gradient, or a chemical potential, or an electromagnetic radiation, into electricity.

The power generating cell 3 generates a voltage that is communicated, by internal connections not shown, to the contact portions 4. In the illustrated embodiment, two contact portions 4 are provided on the external side of the layer 3. It is however perfectly conceivable to have one or several contact portions on the internal side of the layer 3, or even inside the layer or on a lateral side of the layer. In a preferred embodiment, the contact portions are made of two metal bands (busbars) running perpendicular to the plane of the figure along substantially the full length of the product. The bands may be made of copper, silver or aluminium for example. Their width is preferably sufficient for transporting the current produced by a large-size solar cell product and to allow for an easy connection from the internal side, but minimal so as to reduce the surface of solar cells shadowed.

The external layer 5 is an encapsulation layer 5 used for sealing the product and preventing infiltrations of water or dust, which may damage the power generating cell 3. It is preferably made of one or several transparent organic materials. In another embodiment, a glass plate is used for encapsulating the solar cell element.

This structure of layers is given as an example only; the one skilled in the art will understand that other layers may be used within the scope of the invention.

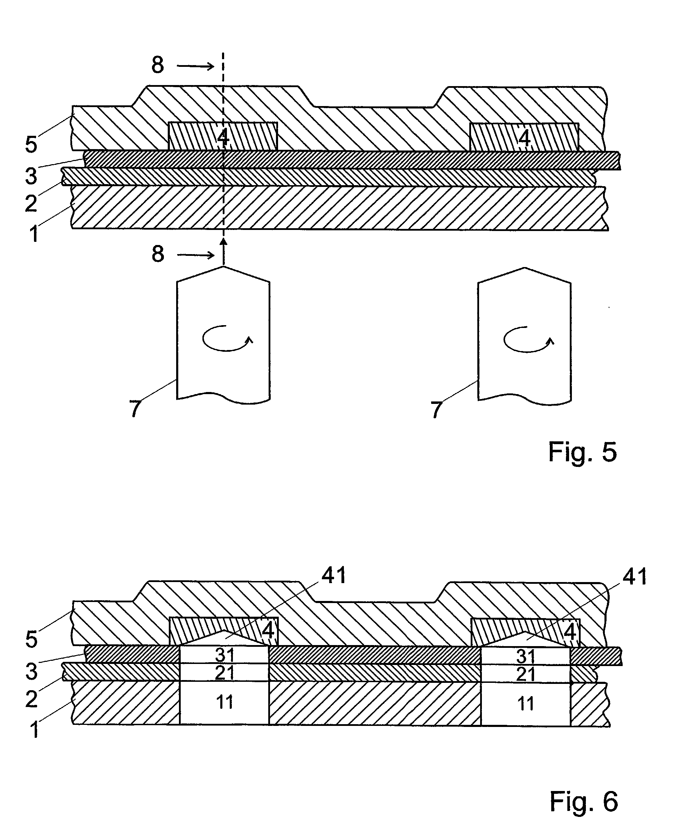

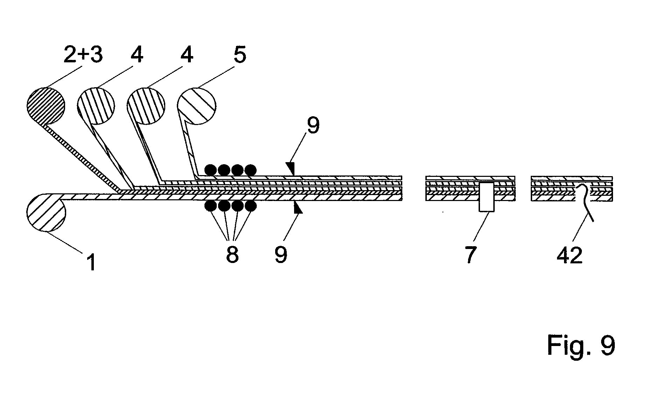

The layers shown on Figure 4 are laminated together, for example by a rolling device such as the one schematically illustrated on Figure 9. It is possible to laminate the layers in one or several steps. The product can be cut to the desired dimensions before or preferably after the lamination process. Figure 5 illustrates the laminated layers at the output of the rolling device. One sees that at this stage of the fabrication process, the contact portions 4 are completely sealed and not accessible from the outside of the product.

According to the invention, blind holes 11, 21, 31, 41 are perforated from the internal side of the product after the laminating process in order to provide an access to the contact portions 4. In the preferred illustrated embodiment, those blind holes are drilled at predetermined positions, corresponding to the positions of the contact portions 4, using drills 7. This solution has the advantage that the depth of the blind hole and its position can be controlled with a very high precision. It is even possible to drill holes of different depths to access contact portions established on different layers of the product. Other hole perforating methods, including mills, laser, water streams and/or punching, may however be used. Sensing means, for example optical or ultrasound sensors, can be used for detecting when the needed depth has been reached and for stopping the perforation at that moment. In an embodiment, the control of depth is performed by detecting a voltage difference on the drill, produced by a contact with the contact portion 4.

Figure 6 shows a cross-section through a laminated product in which two blind holes 11, 21, 31, 41 have been made to access the two contact portions 4. The lateral sides of the holes are very even, whereas their bottom, in this example, consists of a conical mark in the metal of the contact portion 4.

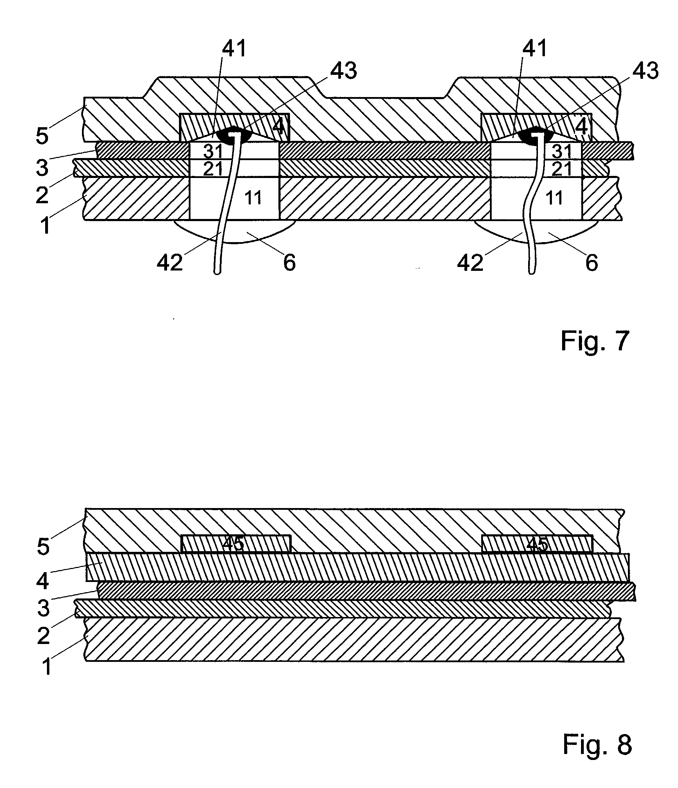

Once the blind holes have been perforated, electrical connectors 42 can be led through the base plate and electrically connected to the contact portions 4. In the embodiment illustrated on Figure 7, the electrical connectors are made of wires 42 welded to the contact portions, the reference number 43 showing the weld. Adhesion between the weld and the contact portion is facilitated by the uneven surface of the bottom of the hole. Leading of the wire through the hole is facilitated by the lateral sides of the hole being even. Electrical conductors other than wires can be used for establishing a connection with the contact portions 4.

Sealing material 6 is preferably injected into each blind hole for preventing infiltration of water or dust from the internal side of the product. A junction box (not illustrated) may further be mounted over each blind hole for providing an easier mutual connection between products mounted on a same wall or roof.

Figure 8 shows a cross-section perpendicular to the cross-sections shown on Figures 1 to 7 of another embodiment of the inventive product, before the perforation of the blind holes. In this embodiment, the contact portions 4 are locally reinforced with a supplementary layer of metal 45 where the blind holes should be perforated. This reduces the risk of damaging the encapsulation layer 5 during the perforation of the blind holes, and relaxes the constraints on the control of perforation depth.

Figure 9 illustrates a device for fabricating the sealed product of the invention. In the illustrated embodiment, all the layers 1, 2, 3, 4 and 5 are first laminated in one step by the rolling elements 8 and then cut to the right dimensions and shape by the cutting stamps 9. Blind holes are then perforated in each product by drills 7, before leading and welding of the electric conductors 42 in the holes. It is possible however to laminate the different layers in several steps, and even on different machines.

Mechanical connection means can be provided on the base plate 1 for making the sealed product suitable for covering external building walls.

## Claims

1. Sealed electric power generating product including:
a base plate,
a power generating film laminated over said base plate,
at least one contact portion for contacting at least one pole of said power generating film,
an electric conductor going through a blind hole between the internal side of said base plate and said contact portion, said electric conductor being electrically connected with said contact portion,
**characterised in that** said blind hole is a hole perforated through said base plate after the lamination of said power generating film over said base plate.

2. The product of claim 1, wherein said at least one contact portion is provided on the upper side of said film opposite said base plate, said blind hole traversing said base plate and said film.

3. The product of one of the claims 1 or 2, wherein said contact portion comprises a metallic band running along substantially the full length of said film.

4. The product of claim 3, comprising two metallic bands running along two opposite sides of said film, and at least two electric conductors going through two blind holes for connecting each said metallic band.

5. The product of one of the claims 1 to 4, wherein said base plate is a rigid plate.

6. The product of one of the claims 1 to 5, wherein said base plate comprises at least one metal layer.

7. The product of claim 6, wherein said base plate comprises one layer of insulator between two layers of metal.

8. The product of one of the claims 1 to 4, wherein said base plate is suitable for covering external building walls.

9. The product of one of the claims 1 to 8, wherein said power generating film comprises a plurality of silicon layers over a flexible substrate.

10. The product of one of the claims 1 to 9, further comprising a transparent encapsulation layer over said photovoltaic film, said encapsulation layer being made of an organic material.

11. The product of one of the claims 1 to 10, further comprising sealing material for sealing said blind holes.

12. A process for making a sealed electric power generating product, comprising:
providing a base plate,
laminating a power generating film over said base plate,
providing at least one contact portion for electrically contacting said power generating film.
perforating a blind hole through said base plate for accessing said contact portion from the internal side,
leading an electric conductor through each said blind hole,
electrically connecting said electric conductor with said contact portion.
